# EUROPEAN PATENT APPLICATION

(11) **EP 4 604 125 A1**
(43) Date of publication of application: **20.08.2025**
(21) Application number: 24217525.5
(22) Date of filing: 04.12.2024
(51) Int. Cl.: G11C 29/00, G11C 29/44, G11C 7/06, G11C 11/4091

(54) **MEMORY INCLUDING SENSE AMPLIFIER AND OPERATION METHOD OF MEMORY**

(30) Priority: 14.02.2024 KR 20240020745
(71) Applicant: SK hynix Inc., Bubal-eub Icheon-si Gyeonggi-do 17336 (KR)
(72) Inventor: KU, Sang Hyun, 17336 Icheon-si, Gyeonggi-do (KR); KIM, Do Hong, 17336 Icheon-si, Gyeonggi-do (KR); KIM, So Yoon, 17336 Icheon-si, Gyeonggi-do (KR); SEOK, Min Ho, 17336 Icheon-si, Gyeonggi-do (KR); HONG, Duck Hwa, 17336 Icheon-si, Gyeonggi-do (KR)
(74) Representative: Isarpatent

(57) **Abstract**

An operation method of a memory may include receiving a first active command and a first row address; starting a first mismatch compensation operation in a sense amplifier array for a normal cell array corresponding to the first row address and in a redundancy sense amplifier array for a redundancy cell array corresponding to the normal cell array; determining whether to access the normal cell array based on the first row address and repair information; deactivating the redundancy sense amplifier array for the redundancy cell array in response to a determination that the normal cell array is to be accessed; activating a word line of the normal cell array corresponding to the first row address; and sensing and amplifying, by the sense amplifier array for the normal cell array, data of memory cells corresponding to the activated word line.

## Description

### BACKGROUND

### 1. Technical Field

Embodiments of the present disclosure relate to a memory, and more particularly, to data sensing in the memory.

### 2. Related Art

A memory uses a sense amplifier in order to sense and amplify data in a memory cell. The sense amplifier senses and amplifies a small voltage difference between bit lines. When even a small potential difference exists between the bit lines, the sense amplifier ideally needs to accurately sense and amplify the potential difference. However, in reality, this is not possible.

A minimum value of the potential difference between the bit lines for the sense amplifier to accurately sense data is referred to as an offset voltage. When the potential difference across the bit lines is smaller than the offset voltage, the sense amplifier might not perform accurate amplification and sensing operations. A factor causing the offset voltage may include a mismatch between PMOS transistors and NMOS transistors constituting the sense amplifier. The PMOS transistors and the NMOS transistors constituting the sense amplifier need to be identically manufactured, but a mismatch always exists because the PMOS transistors and the NMOS transistors are not able to be completely identically manufactured in reality.

### SUMMARY

In an embodiment of the present disclosure, an operation method of a memory may include: receiving a first active command and a first row address; starting a first mismatch compensation operation in a sense amplifier array for a normal cell array corresponding to the first row address and in a redundancy sense amplifier array for a redundancy cell array corresponding to the normal cell array; determining whether to access the normal cell array based on the first row address and repair information; deactivating the redundancy sense amplifier array for the redundancy cell array in response to a determination that the normal cell array is to be accessed; activating a word line of the normal cell array corresponding to the first row address; and sensing and amplifying, by the sense amplifier array for the normal cell array, data of memory cells corresponding to the activated word line.

In an embodiment of the present disclosure, a memory may include a normal cell array; a normal sense amplifier array that senses and amplifies data of the normal cell array; a redundancy cell array; a redundancy sense amplifier array that senses and amplifies data of the redundancy cell array; and a repair determination circuit that determines whether to access the redundancy cell array based on a row address and repair information, wherein a mismatch compensation operation of the normal sense amplifier array and the redundancy sense amplifier array may start in response to an application of an active command, and after the determination of the repair determination circuit, one of the normal sense amplifier array and the redundancy sense amplifier array may be deactivated.

### BRIEF DESCRIPTION OF THE DRAWINGS

FIG. 1 is a diagram illustrating a configuration of a memory in accordance with an embodiment of the present disclosure.
FIG. 2 is a diagram illustrating a detailed configuration of a memory bank in FIG. 1, in accordance with an embodiment of the present disclosure.
FIG. 3 is a diagram illustrating a detailed configuration of a sense amplifier included in a normal sense amplifier array in FIG. 2, in accordance with an embodiment of the present disclosure.
FIG. 4 is a timing diagram for describing operations of the sense amplifier in FIG. 3, in accordance with an embodiment of the present disclosure.
FIG. 5 is a flowchart for describing an active operation of the memory, in accordance with an embodiment of the present disclosure.
FIG. 6 is a flowchart for describing an active operation of the memory, in accordance with an embodiment of the present disclosure.
FIG. 7 is a timing diagram of a sense amplifier that performs operations in FIG. 6, in accordance with an embodiment of the present disclosure.

### DETAILED DESCRIPTION

Various embodiments of the present disclosure are directed to a memory with a reduced access time while reducing a mismatch in a sense amplifier.

According to embodiments of the present disclosure, an access time may be reduced while reducing a mismatch in a sense amplifier.

Hereafter, embodiments in accordance with the technical spirit of the present disclosure will be described with reference to the accompanying drawings.

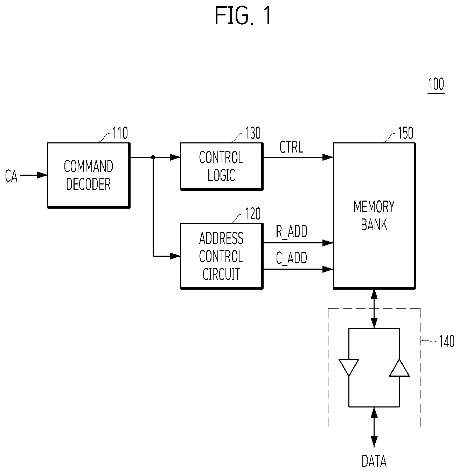

FIG. 1 is a diagram illustrating a configuration of a memory 100 in accordance with an embodiment of the present disclosure.

Referring to FIG. 1, the memory 100 may include a command decoder 110, an address control circuit 120, a control logic 130, a data transmission/reception circuit 140, and a memory bank 150.

The command decoder 110 may determine a type of an operation instructed by a memory controller (not shown) to the memory 100 by decoding a command/address CA received from the memory controller. For example, the command decoder 110 may determine whether an active operation, a precharge operation, a refresh operation, a write operation, or a read operation is instructed.

The control logic 130 may control internal components of the memory 100 according to the decoding result of the command decoder 110. Control signals CTRL may indicate signals for the control logic 130 to control the internal components of the memory 100.

The address control circuit 120 may classify addresses received from the command decoder 110 into a row address R_ADD and a column address C_ADD, and transmit the row address R_ADD and the column address C_ADD to the memory bank 150. The address control circuit 120 may recognize the address as the row address R_ADD when a row operation (e.g., an active operation) is instructed according to the decoding result of the command decoder 110, and recognize the address as the column address C_ADD when a column operation (i.e., a read operation and a write operation) is instructed.

The data transmission/reception circuit 140 may receive data DATA or transmit the data DATA. The data transmission/reception circuit 140 may receive the data DATA to be written to the memory bank 150 during a write operation, and may transmit the data DATA read from the memory bank 150 during a read operation.

The memory bank 150 on which an active operation, a precharge operations, a read operation, and a write operation are performed may include components for storing data and accessing the data. Although FIG. 1 illustrates only one memory bank 150, it is natural that the memory 100 may include a plurality of memory banks 150.

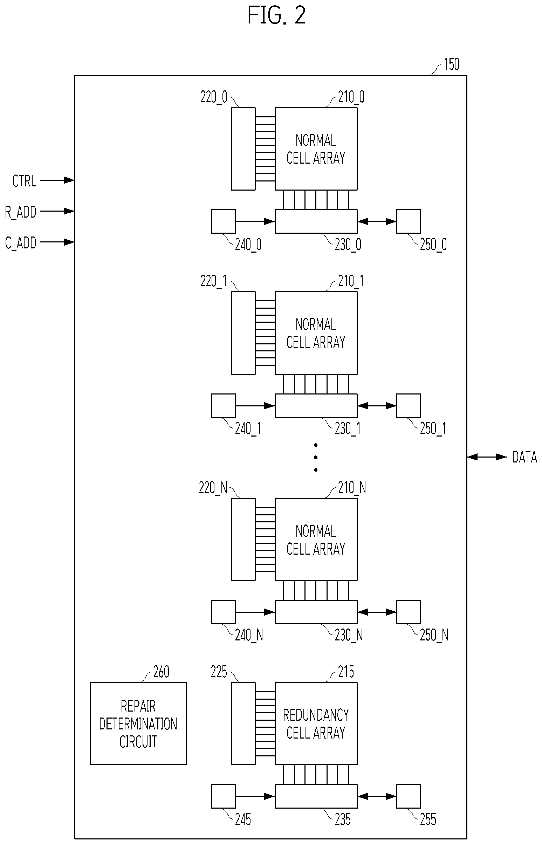

FIG. 2 is a diagram illustrating a detailed configuration of the memory bank 150 in FIG. 1, in accordance with an embodiment of the present disclosure.

Referring to FIG. 2, the memory bank 150 may include normal cell arrays 210_0 to 210_N, where N is an integer of 1 or more, a redundancy cell array 215, normal row circuits 220_0 to 220_N, a redundancy row circuit 225, normal sense amplifier arrays 230_0 to 230_N, a redundancy sense amplifier array 235, normal sense amplifier array control circuits 240_0 to 240_N, a redundancy sense amplifier array control circuit 245, normal column circuits 250_0 to 250_N, a redundancy column circuit 255, and a repair determination circuit 260.

Each of the normal cell arrays 210_0 to 210_N may include a plurality of word lines, a plurality of bit lines, and a plurality of memory cells formed at intersections of the word lines and the bit lines. Each of the memory cells may include a capacitor for storing data and a transistor serving as a switch.

The normal row circuits 220_0 to 220_N may perform an active operation of activating a word line selected by the row address R_ADD among the plurality of word lines included in the normal cell arrays 210_0 to 210_N. Depending on a value of the row address R_ADD, one of the normal row circuits 220_0 to 220_N may activate the word line selected by the row address R_ADD. For example, when the value of the row address R_ADD is 0 to 511, the normal row circuit 220_0 may activate a word line corresponding to the value of the row address R_ADD, and when the value of the row address R_ADD is 512 to 1023, the normal row circuit 220_1 may activate the word line corresponding to the value of the row address R_ADD.

The normal sense amplifier arrays 230_0 to 230_N may sense and amplify data stored in the memory cells of the normal cell arrays 210_0 to 210_N during an active operation. Depending on the value of the row address R_ADD, one of the normal sense amplifier arrays 230_0 to 230_N may be activated and operated. For example, when the value of the row address R_ADD is 0 to 511, the normal sense amplifier array 230_0 may operate, and when the value of the row address R_ADD is 512 to 1023, the normal sense amplifier array 230_1 may operate.

The normal sense amplifier array control circuits 240_0 to 240_N may control operations of the normal sense amplifier arrays 230_0 to 230_N. The normal sense amplifier arrays 230_0 to 230_N may perform a mismatch compensation operation and a sense amplification operation. The mismatch compensation operation may be an operation performed before the sense amplification operation in order to reduce a mismatch of sense amplifiers of the sense amplifier arrays 230_0 to 230_N, and the sense amplification operation may be an operation of sensing and amplifying data in the memory cells.

The normal column circuits 250_0 to 250_N may access data of sense amplifiers selected by the column address C_ADD among the sense amplifiers of the normal sense amplifier arrays 230_0 to 230_N during read and write operations. Depending on the value of the column address C_ADD, one of the normal column circuits 250_0 to 250_N may be activated and operated. For example, when the value of the column address C_ADD is 0 to 511, the normal column circuit 250_0 may access the data of the sense amplifiers selected by the column address C_ADD among the sense amplifiers of the normal sense amplifier array 230_0, and when the value of the column address C_ADD is 512 to 1023, the normal column circuit 250_1 may access the data of the sense amplifiers selected by the column address C_ADD among the sense amplifiers of the normal sense amplifier array 230_1.

The repair determination circuit 260 may determine whether to access the redundancy cell array 215 by using the row address R_ADD and repair information. The repair information may be information on a defective row stored in the repair determination circuit 260. For example, the repair information may include information indicating that row 100 and row 760 are defective. When the row address R_ADD matches the repair information, the repair determination circuit 360 may provide a determination result to the normal row circuits 220_0 to 220_N and the sense amplifier array control circuits 240_0 to 240_N and 245 so that the redundancy cell array 215 may be accessed instead of the normal cell arrays 210_0 to 210_N.

The repair information of the repair determination circuit 260 includes information indicating that the row 100 is defective, and when the value of the row address R_ADD is 100, one of redundancy word lines of the redundancy cell array 215 may be accessed instead of word line 100 of the normal cell array 210_0.

The redundancy cell array 215 may include redundancy memory cells for replacing memory cells of defective rows of the normal cell arrays 210_0 to 210_N. The redundancy row circuit 225 may drive the redundancy word lines of the redundancy cell array 215, and the redundancy sense amplifier array 235 may sense and amplify the data of memory cells of the redundancy cell array 215. The redundancy sense amplifier array control circuit 245 may control the redundancy sense amplifier array 235.

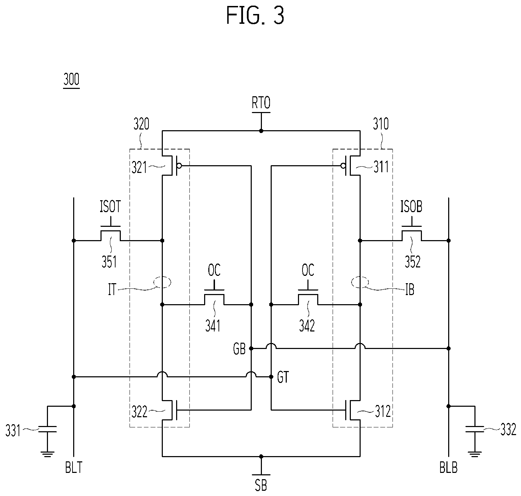

FIG. 3 is a diagram illustrating a detailed configuration of the sense amplifier 300 included in the normal sense amplifier array 230_0 in FIG. 2, in accordance with an embodiment of the present disclosure.

Referring to FIG. 3, the sense amplifier 300 may include a first inverter 310, a second inverter 320, a first offset canceling switch 341, a second offset canceling switch 342, a first isolation switch 351, and a second isolation switch 352. The sense amplifier 300 is also referred to as a bit line sense amplifier because the sense amplifier 300 amplifies a voltage difference between bit lines BLT and BLB.

An input terminal of the first inverter 310 may be connected to a first bit line BLT through a first sensing node GT, and an output terminal of the first inverter 310 may be connected to a second inner bit line IB. An input terminal of the second inverter 320 may be connected to a second bit line BLB (i.e., a complementary bit line of the first bit line BLT) through a second sensing node GB, and an output terminal of the second inverter 320 may be connected to a first inner bit line IT. The first inverter 310 may be formed by connecting a PMOS transistor 311 and a NMOS transistor 312 in series between a pull-up voltage terminal RTO and a pull-down voltage terminal SB, and the second inverter 320 may be formed by connecting a PMOS transistor 321 and a NMOS transistor 322 in series between the pull-up voltage terminal RTO and the pull-down voltage terminal SB.

The first offset canceling switch 341 may electrically connect the first inner bit line IT and the second sensing node GB (i.e., the second bit line BLB) in response to an offset canceling signal OC. The second offset canceling switch 342 may electrically connect the second inner bit line IB and the first sensing node GT (i.e., the first bit line BLT) in response to the offset canceling signal OC. Each of the first offset canceling switch 341 and the second offset canceling switch 342 may be implemented as an NMOS transistor.

The first isolation switch 351 may electrically connect the first bit line BLT and the first inner bit line IT in response to a first isolation signal ISOT. The second isolation switch 352 may electrically connect the second bit line BLB and the second inner bit line IB in response to a second isolation signal ISOB. Each of the first isolation switch 351 and the second isolation switch 352 may be implemented with an NMOS transistor. The first isolation signal ISOT and the second isolation signal ISOB may be signals that are sequentially turned on during a sensing operation.

A first capacitor 331 may be connected to the first bit line BLT, and a second capacitor 332 may be connected to the second bit line BLB. The first capacitor 331 and the second capacitor 332 are parasitic capacitors, and during a mismatch compensation operation, offsets of the first inverter 310 and the second inverter 320 may be stored in the parasitic capacitors 331 and 332, respectively. The offsets of the first inverter 310 and the second inverter 320 may be stored in the first capacitor 331 and the second capacitor 332, respectively.

Voltage levels of the offset canceling signal OC, the first isolation signal ISOT, the second isolation signal ISOB, the pull-up voltage stage RTO, and the pull-down voltage stage SB may be controlled by the normal sense amplifier array control circuit 240_0.

The normal sense amplifier array 230_0 may include a plurality of sense amplifiers 300, and the normal sense amplifier arrays 230_0 to 230_N and the redundancy sense amplifier array 235 may also include a plurality of sense amplifiers configured as illustrated in FIG. 3.

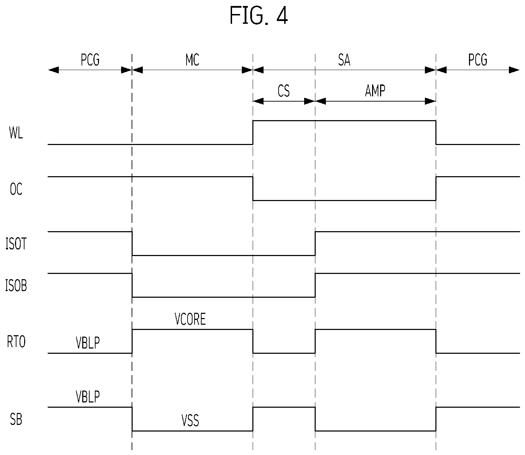

FIG. 4 is a timing diagram for describing the operations of the sense amplifier 300 in FIG. 3, in accordance with an embodiment of the present disclosure.

Referring to FIGS. 3 and 4, the operations of the sense amplifier 300 may include a precharge operation PCG, a mismatch compensation operation MC, and a sense amplification operation SA.

During the precharge operation PCG, the first isolation signal ISOT, the second isolation signal ISOB, and the offset canceling signal OC may be activated to a logic high level. A precharge voltage VBLP may be applied to the pull-up voltage stage RTO and the pull-down voltage stage SB. Because the same level of voltage is applied to the pull-up voltage terminal RTO and the pull-down voltage terminal SB, the sense amplifier 300 may be in a deactivated state in which the inverters 310 and 320 are deactivated. During the precharge operation PCG, the first bit line BLT and the second bit line BLB may be at a level of the precharge voltage VBLP.

During the mismatch compensation operation MC, in a state in which the offset canceling signal OC is activated to a logic high level, the first isolation signal ISOT and the second isolation signal ISOB may be deactivated to a logic low level. The first offset canceling switch 341 and the second offset canceling switch 342 are turned on and the first isolation switch 351 and the second isolation switch 352 are turned off, so that both the input terminal and the output terminal of the first inverter 310 may be connected to the first bit line BLT and both the input terminal and the output terminal of the second inverter 320 may be connected to the second bit line BLB. A core voltage VCORE (a power supply voltage used in the sense amplifier) is supplied to the pull-up voltage stage RTO and a ground voltage VSS is supplied to the pull-down voltage stage SB, so that the first inverter 310 and the second inverter 320 may be activated. As a result, a kind of equilibrium state reflecting the offsets of the transistors 311 and 312 of the first inverter 310 may be stored in the first capacitor 331, and a kind of equilibrium state reflecting the offsets of the transistors 321 and 322 of the second inverter 320 may be stored in the second capacitor 332. Because a subsequent operation is performed in a state in which the offsets of the transistors 311, 312, 321, and 322 of the first and second inverters 310 and 320 are reflected in the capacitors 331 and 332 by the mismatch compensation operation MC, an effect of mismatch may be minimized in the subsequent operation.

The sense amplification operation SA may include a charge sharing section CS and an amplification section AMP. In the charge sharing section CS, the first isolation signal ISOT, the second isolation signal ISOB, and the offset canceling signal OC may be deactivated to a logic low level, and the bit line precharge voltage VBLP may be applied to the pull-up voltage terminal RTO and the pull-down voltage terminal SB. Subsequently, the word line WL is activated, so that data in a memory cell connected to the word line WL may be charge-shared with one of the bit lines BLT and BLB. That is, the voltage level of one of the bit lines BLT and BLB may be increased or decreased depending on the data value of the memory cell.

In the amplification section AMP, the first isolation signal ISOT and the second isolation signal ISOB are activated to a logic high level, the core voltage VCORE is supplied to the pull-up voltage stage RTO, and the ground voltage VSS is supplied to the pull-down voltage stage SB, so that an amplification operation of amplifying a voltage difference between the bit lines BLT and BLB may be performed by the inverters 310 and 320.

When the sense amplification operation SA ends, the precharge operation PCG may start again, and during the precharge operation PCG, the first isolation signal ISOT, the second isolation signal ISOB, and the offset canceling signal OC may be activated to a logic high level. The precharge voltage VBLP may be applied to the pull-up voltage stage RTO and the pull-down voltage stage SB.

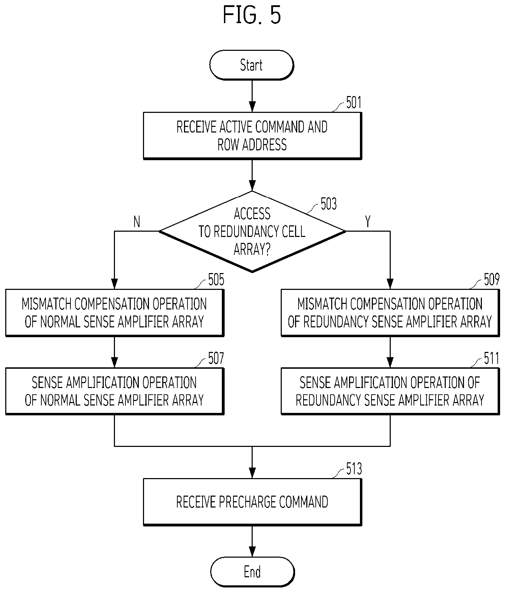

FIG. 5 is a flowchart for describing an active operation of the memory 100, in accordance with an embodiment of the present disclosure.

Referring to FIG. 5, the active operation of the memory 100 may start by receiving an active command and a row address (501). The command decoder 110 may decode the command and the address CA to ascertain that the memory controller has instructed the memory 100 to perform the active operation, and the address control circuit 120 may classify the address received from the command decoder 110 as the row address R_ADD. For convenience of description, the value of the row address R_ADD is 32 however other values may be used.

The repair determination circuit 260 may determine whether to access the redundancy cell array 215 by using the row address R_ADD and the repair information (503). The repair information stores values of a row address corresponding to a defect, and the repair determination circuit 260 may determine whether the value of the received row address R_ADD matches one of the values of the row address included in the repair information.

When the row address R_ADD does not match the value of the defective address included in the repair information, access to a normal cell array may be determined (i.e., 'N' in 503). Because the value of the row address R_ADD is 32, the normal cell array 210_0 may be accessed. The normal sense amplifier array control circuit 240_0 may control the sense amplifiers of the normal sense amplifier array 230_0 to sequentially perform the mismatch compensation operation 505 and the sense amplification operation 507. During a sense amplification operation, the normal row circuit 220_0 may activate word line 32 selected by the row address R_ADD.

When the row address R_ADD matches one of the values of the defective address included in the repair information, access to the redundancy cell array 215 may be determined (i.e., 'Y' in 503). The redundancy sense amplifier array control circuit 245 may control the sense amplifiers of the redundancy sense amplifier array 235 to sequentially perform the mismatch compensation operation 509 and the sense amplification operation 511. During a sense amplification operation, the redundancy row circuit 225 may activate a redundancy word line designated to replace the word line 32 among the redundancy word lines.

The active operation may end by receiving a precharge command (513). The command decoder 110 may decode the command/address CA to ascertain that the memory controller has instructed the memory 100 to perform a precharge operation, and the precharge operation of ending the active operation may be performed. Although not illustrated in the drawing, read and write operations may be performed in the memory 100 during the active operation.

In the memory 100, the time required from the point of application of the active command until data of memory cells of a selected row is sensed and amplified, that is, the time from the point of application of the active command until the read and write operations can be performed is referred to as row address to column address delay (tRCD), and this is one of very important performance indicators in the memory 100.

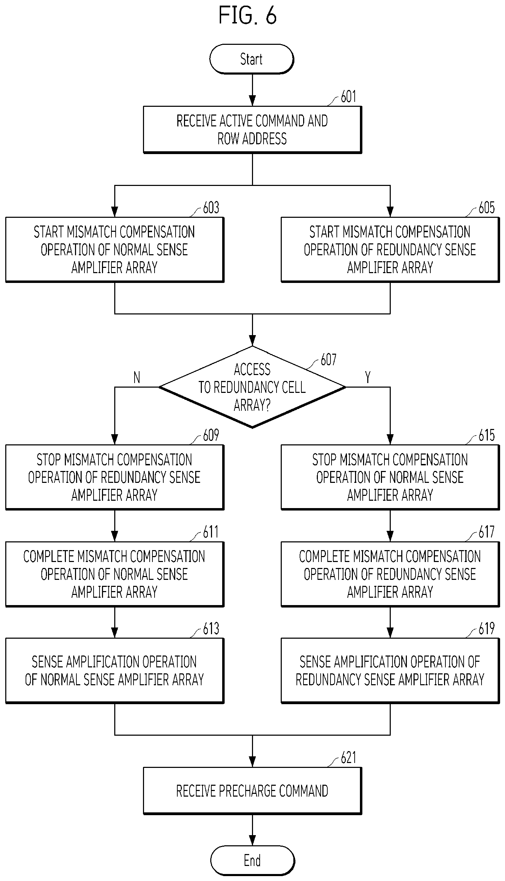

FIG. 6 is a flowchart for describing the active operation of the memory 100, in accordance with an embodiment of the present disclosure. Changes are made to the active operation in order to reduce tRCD compared to FIG. 5.

Referring to FIG. 6, the active operation of the memory 100 may start by receiving an active command and a row address (601). The command decoder 110 may decode the command and the address CA to ascertain that the memory controller has instructed the memory 100 to perform the active operation, and the address control circuit 120 may classify the address received from the command decoder 110 as the row address R_ADD. For convenience of description, the value of the row address R_ADD is 32 as an example.

The mismatch compensation operation of the normal sense amplifier array may start (603), and the mismatch compensation operation of the redundancy sense amplifier array may start in parallel (605). In FIG. 5, the mismatch compensation operation is performed in one of the normal sense amplifier array and the redundancy sense amplifier array after the determination of the repair determination circuit 260, but in FIG. 6, the mismatch compensation operation may start in both the normal sense amplifier array and the redundancy sense amplifier array before the determination of the repair determination circuit 260 in order to avoid delay. Because the value of the row address R_ADD is 32, the mismatch compensation operation of the normal sense amplifier array 230_0 and the redundancy sense amplifier array 235 may start.

The repair determination circuit 260 may determine whether to access the redundancy cell array 215 by using the row address R_ADD and the repair information (607).

When the access to the redundancy cell array is not determined (i.e., 'N' in 607), the mismatch compensation operation of the redundancy sense amplifier array may stop (609). The mismatch compensation operation of the normal sense amplifier array may be continuously performed and completed (611). Subsequently, a sense amplification operation of the normal sense amplifier array may be performed (613).

When the access to the redundancy cell array is determined (i.e., 'Y' in 607), the mismatch compensation operation of the normal sense amplifier array may stop (615). The mismatch compensation operation of the redundancy sense amplifier array may be continuously performed and completed (617). Subsequently, a sense amplification operation of the redundancy sense amplifier array may be performed (619).

The active operation may end by receiving a precharge command (621). The command decoder 110 may decode the command/address CA to determine that the memory controller has instructed the memory 100 to perform a precharge operation, and the precharge operation of ending the active operation may be performed. Although not illustrated in the drawing, read and write operations may also be performed in the memory 100 during the active operation.

In FIG. 6, a mismatch compensation operation may start in parallel in the normal sense amplifier array and the redundancy sense amplifier array before the determination operation of the repair determination circuit 260. The determination operation of the repair determination circuit 260 may take a considerable amount of time, but through such an operation, time delay may be minimized and, as a result, tRCD may be reduced. After the determination operation of the repair determination circuit 260, because the mismatch compensation operation of the sense amplifier array that requires no active operation between the normal sense amplifier array and the redundancy sense amplifier array stops, current consumption may be minimized.

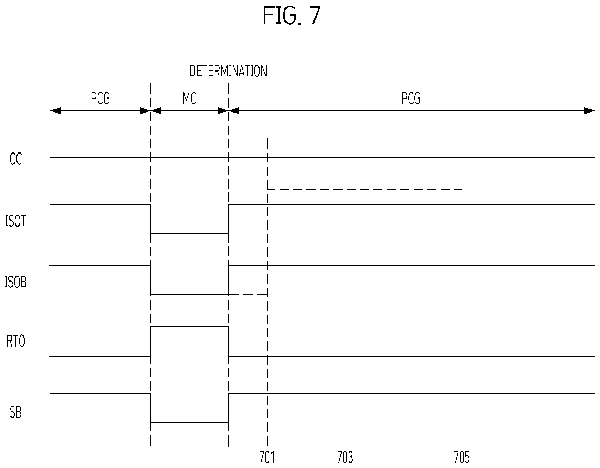

FIG. 7 is a timing diagram of a sense amplifier that performs the operations (605, 609) or (603, 615) in FIG. 6, in accordance with an embodiment of the present disclosure.

Referring to FIG. 7, the sense amplifier may start a mismatch compensation operation MC in response to an active command during a precharge operation PCG. When the determination operation of the repair determination circuit 260 is completed during the mismatch compensation operation MC and the mismatch compensation operation MC is determined to stop, the sense amplifier may confirm returning to the state of the precharge operation PCG again.

The sense amplifier that performs the operations (603, 611, 613) or (605, 617, 619) in FIG. 6 may operate in the same manner as the timing diagram of FIG. 4, and this is indicated by dotted lines in FIG. 7. In such a case, the mismatch compensation operation may be performed until time point 701, the operation of the charge sharing section CS may be performed from time point 701 to time point 703, and the operation of the amplification section AMP may be performed from time point 703 to time point 705. At time point 705, the precharge operation may be performed again.

Although embodiments according to the technical idea of the present disclosure have been described above with reference to the accompanying drawings, this is only for describing the embodiments according to the concept of the present disclosure, and the present disclosure is not limited to the above embodiments. Various types of substitutions, modifications, and changes for the embodiments may be made by those skilled in the art, to which the present disclosure pertains, without departing from the technical idea of the present disclosure defined in the following claims, and it should be construed that these substitutions, modifications, and changes belong to the scope of the present disclosure. Furthermore, the embodiments may be combined to form additional embodiments.

## Claims

1. An operation method of a memory, the operation method comprising:
receiving a first active command and a first row address;
starting a first mismatch compensation operation in a sense amplifier array for a normal cell array corresponding to the first row address and in a redundancy sense amplifier array for a redundancy cell array corresponding to the normal cell array;
determining whether to access the normal cell array based on the first row address and repair information;
deactivating the redundancy sense amplifier array for the redundancy cell array in response to a determination that the normal cell array is to be accessed;
activating a word line of the normal cell array corresponding to the first row address; and
sensing and amplifying, by the sense amplifier array for the normal cell array, data of memory cells corresponding to the activated word line.

2. The operation method of a memory of claim 1, further comprising:
receiving a precharge command;
deactivating the activated word line in response to the precharge command; and
deactivating the sense amplifier array for the normal cell array in response to the precharge command.

3. The operation method of a memory of claim 2, further comprising:
receiving a second active command and a second row address;
starting a second mismatch compensation operation in a sense amplifier array for a normal cell array corresponding to the second row address and in the redundancy sense amplifier array for the redundancy cell array;
determining to access the redundancy cell array based on the second row address and the repair information;
deactivating the sense amplifier array for the normal cell array in response to a determination that the redundancy cell array is to be accessed;
activating a redundancy word line of the redundancy cell array; and
sensing and amplifying, by the sense amplifier array for the redundancy cell array, data of memory cells corresponding to the activated redundancy word line.

4. The operation method of a memory of claim 1, the first mismatch compensation operation is performed in parallel in the sense amplifier array for the normal cell array corresponding to the first row address and in the redundancy sense amplifier array corresponding to the normal cell array.

5. The operation method of a memory of claim 3, the second mismatch compensation operation is performed in parallel in the sense amplifier array for the normal cell array corresponding to the second row address and in the redundancy sense amplifier array.

6. A memory comprising:
a normal cell array;
a normal sense amplifier array configured to sense and amplify data of the normal cell array;
a redundancy cell array;
a redundancy sense amplifier array configured to sense and amplify data of the redundancy cell array; and
a repair determination circuit configured to determine whether to access the redundancy cell array based on a row address and repair information,
wherein a mismatch compensation operation of the normal sense amplifier array and the redundancy sense amplifier array starts in response to an active command, and
wherein, after the determination of the repair determination circuit, one of the normal sense amplifier array and the redundancy sense amplifier array is deactivated.

7. The memory of claim 6, wherein, when the repair determination circuit determines to access the normal cell array:
the redundancy sense amplifier array is deactivated;
a word line of the normal cell array corresponding to the row address is activated; and
the normal sense amplifier array senses and amplifies data of memory cells corresponding to the word line.

8. The memory of claim 6, wherein, when the repair determination circuit determines to access the redundancy cell array:
the normal sense amplifier array is deactivated;
a redundancy word line of the redundancy cell array is activated; and
the redundancy sense amplifier array senses and amplifies data of memory cells corresponding to the redundancy word line.

9. The memory of claim 6, further comprising:
a normal row circuit configured to drive word lines of the normal cell array;
a normal sense amplifier array control circuit configured to control the normal sense amplifier array;
a redundancy row circuit configured to drive redundancy word lines of the redundancy cell array; and
a redundancy sense amplifier array control circuit configured to control the redundancy sense amplifier array.

10. The memory of claim 9, wherein, in response to the active command, the normal sense amplifier array control circuit controls the normal sense amplifier array to start the mismatch compensation operation and the redundancy sense amplifier array control circuit controls the redundancy sense amplifier array to start the mismatch compensation operation, and
wherein, in response to the determination of the repair determination circuit, one of the normal sense amplifier array control circuit and the redundancy sense amplifier array control circuit deactivates a sense amplifier array corresponding thereto.

11. The memory of claim 10, wherein, in response to the determination of the repair determination circuit, one of the normal row circuit and the redundancy row circuit activates one of word lines corresponding thereto.

12. The memory of claim 11, wherein, when access to the normal cell array is determined as a result of the determination of the repair determination circuit, the normal row circuit activates a word line selected by the row address among the word lines.

13. The memory of claim 11, wherein, when access to the redundancy cell array is determined as a result of the determination of the repair determination circuit, the redundancy row circuit activates a redundancy word line designated to replace a word line selected by the row address among the redundancy word lines.
